# EUROPEAN PATENT SPECIFICATION

(11) **EP 4 461 698 B1**
(45) Date of publication and mention of the grant of the patent: **22.04.2026**
(21) Application number: 24175103.1
(22) Date of filing: 10.05.2024
(51) Int. Cl.: B67D 1/08, H03K 17/97, E03C 1/044, H03K 17/975, G05G 1/08, H03K 17/96

(54) **CONTROL KNOB FOR A BEVERAGE DISPENSER**
STEUERKNOPF FÜR EINEN GETRÄNKESPENDER
BOUTON DE COMMANDE POUR DISTRIBUTEUR DE BOISSONS

(30) Priority: 10.05.2023 EP 23172688
(43) Date of publication of application: 13.11.2024
(73) Proprietor: Aqualex NV, 8540 Deerlijk (BE)
(72) Inventor: VANLERBERGHE, Alexander, 8791 Beveren-Leie (BE); PEELMAN, Karel, 8720 Dentergem (BE)
(74) Representative: Winger

(56) References cited:
- EP-A1- 2 814 048
- FR-A3- 2 935 497
- US-A1- 2004 204 779
- US-A1- 2020 140 794
- US-B2- 10 890 332

## Description

### Technical field of the invention

The present invention relates to beverage dispensers, and more particularly to controls for such beverage dispensers; especially controls suitable for selecting between a plurality of beverages out of a beverage tap, such as a water tap.

### Background of the invention

Drinking water systems like water taps (e.g. kitchen taps) have gained renewed attention in recent years as people have become more health-conscious and aware of the importance of drinking clean, safe and durable water. With this movement, these systems have been further developed and have become increasingly sophisticated, allowing for the preparation and dispensing of not only warm and cold water but also filtered, chilled, sparkling, hot and/or enhanced water. To operate a traditional water tap, the user typically manipulates one or more knobs or levers which mechanically control the flow through a valve assembly (e.g. a mixer valve). However, with more options to select from, these controls are no longer practical and more advanced alternatives are desired.

Water taps with push buttons (also referred to as 'press buttons')-coupled to one or more electrically-controlled valves-integrated into the tap or provided on a separate pad are known. For example, US2020140794A1 describes a rotary knob for a beverage which can also be pressed. However, the push buttons as such have moving parts that are prone to wear and tear, resulting in a shorter lifespan than the rest of the water tap. Moreover, they either have a gap that can accumulate grime and is difficult to clean, becoming a potential source of bacterial contamination, or they have a plastic cover which is typically even more delicate than the aforementioned moving parts. As such, the durability and/or hygiene of push buttons is a weak link compared to the rest of the tap.

Another example of a magnetic rotary knob is disclosed in document FR2935497A3.

Capacitive and resistive touch sensors could partially address these problems, but come with their own issues. For example, even a small amount of water may render them unresponsive. Likewise, also dirt or stains (e.g. due to calcification) can impair their effectiveness.

Furthermore, not only for aesthetic reasons but also for durability and hygiene, it is desirable to make the exterior of the controls (as much as possible) out of the same material as that of the rest of the tap. Indeed, taps are typically made of metallic materials like stainless steel or brass, because of their favourable physicochemical (e.g. hardness, wear resistance, and corrosion resistance) and sanitary (e.g. ease of cleaning) properties.

While the aforementioned challenges have been mainly described from the point of view of water taps, it will be clear that new controls suitable for such taps could likewise be more advantageous for more general beverage taps-and even beverage dispensers in a broad sense (e.g. a beverage machine).

There is thus still a need in the art for controls for beverage dispensers which address at least some of the issues outline above.

### Summary of the invention

It is an object of the present invention to provide a good control knob for a beverage dispenser and a method for using said control knob, as defined in the appended independent claims.

It is a further object of the present invention to provide good tap levers, systems and methods associated therewith. This objective is accomplished by tap levers, systems and methods according to the present invention.

It is an advantage of embodiments of the present invention that the control knob combines a selection ring with a touch button. It is a further advantage of embodiments of the present invention that the selection may be visualized with an electronic selection indicator.

It is an advantage of embodiments of the present invention that the selection ring has a finite number of rotary positions in which it is in equilibrium. It is a further advantage of embodiments of the present invention that the 'snapping' of the selection ring from one rotary position to the next generates a (pleasant) haptic feedback for the user.

It is an advantage of embodiments of the present invention that the touch button lacks moving mechanical parts, which makes it less prone to wear and tear and ensures a longer lifespan. It is a further advantage of embodiments of the present invention that the touch button is sealed and made from metals like stainless steel or brass, with a (relatively) flat surface and lack of crevices, making it less likely to harbour bacteria and easier to clean and sanitize.

It is an advantage of embodiments of the present invention that also the control knob housing is predominantly made from a metals like stainless steel or brass, which have physicochemical and sanitary properties which makes them favourable for use in applications involving drink and/or food for human consumption.

It is an advantage of embodiments of the present invention that the exterior surface of the selection ring may be patterned, thereby helping to increase the grip on-and thus ease of manipulating-the selection ring.

It is an advantage of embodiments of the present invention that the control knob may be used in a wide range of configurations and beverage dispensers. It is a further advantage of embodiments of the present invention that the control knob may be integrated with a traditional tap lever (e.g. a single-lever mixer tap) and/or tap.

It is an advantage of embodiments of the present invention that they can be realized in a relatively straightforward and economical fashion.

In a first aspect, the present invention relates to a control knob for a beverage dispenser, comprising a first input means and a second input means. The first input means comprises: (i) a control knob housing comprising a selection ring rotatable around a central axis; (ii) a first set of magnets arranged about the central axis and rotating with the selection ring; (iii) a second set of magnets arranged about the central axis and remaining stationary, such that rotating the selection ring yields changes in the interaction forces between the rotating first set of magnets and the stationary second set of magnets; and (iv) a convertor for sensing and converting said rotation of the selection ring to an electronic signal, thereby providing a first input signal. The second input means comprises: (v) a touch button integrated with a portion of the control knob housing such that the touch button is responsive to a mechanical force applied on said portion, thereby providing a second input signal.

In a second aspect, the present invention relates to a tap lever having integrated thereon a control knob according to any embodiment of the first aspect.

In a third aspect, the present invention relates to a system comprising: a beverage dispenser; and a control knob according to any embodiment of the first or second aspect.

In a fourth aspect, the present invention relates to a method for using a control knob as defined in any embodiment of the first or second aspect, comprising manipulating the selection ring and/or touch button to make a selection.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG 1 schematically depicts an illustrative beverage system in accordance with the present invention.
FIG 2 schematically depicts an illustrative combi tap control-as visible above e.g. a countertop-in accordance with embodiments of the present invention.
FIG 3 is a cutout view of the full combi tap control of FIG 2.
FIG 4 is an exploded view of the full combi tap control of FIG 2.
FIG 5 schematically depicts an illustrative combi tap control integrated on a tap in accordance with embodiments of the present invention.
FIG 6 schematically depicts an illustrative control knob-as visible above e.g. a countertop-in accordance with embodiments of the present invention.
FIG 7 is a cutout view of the full control knob of FIG 6.
FIG 8 is an exploded view of the full control knob of FIG 6.
FIG 9 schematically depicts an illustrative control knob integrated on a tap in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practised without these specific details. In other instances, well-known methods, structures and techniques have not been shown in detail in order not to obscure an understanding of this description.

The following terms are provided solely to aid in the understanding of the invention.

As used herein, a 'touch button' is to be distinguished from a 'push button'. Push buttons typically have moving mechanical parts (e.g. parts which move relative to another, with some form of gap between them) requiring substantial travel (in the order of millimetres) and force (from a few Newtons to several tens of Newtons) to be responsive. Accordingly, push buttons are generally not responsive to a simple 'touch', i.e. a light mechanical contact (e.g. about 0.5 to 2 N) from e.g. a finger or other body part, or a stylus or similar implement. By contrast, a touch button in accordance with the present invention may typically have a touch area (i.e. the area to be touched in order to operate the button) responsive to a mechanical force of at most 2 N, preferably at most 1 N, most typically a fraction of a Newton (e.g. at most 0.5 N, preferably at most 0.2 N, most preferably at most 0.1 N). Similarly, a maximum travel distance (also called maximum 'stroke' or simply 'travel') of the touch area may be at most 500 µm, preferably at most 200 µm, more preferably at most 100 µm, still more preferably at most 50 µm; such as around 20 to 50 µm. Moreover, substantially no gap may be present between the touch area and a peripheral area (i.e. an area surrounding the touch area) of the touch button. Typically, the touch area may be monolithically-and preferably (quasi-)seamlessly-integrated with at least a further part of the control knob housing. The limited travel distance and mechanical force required to operate a touch button in accordance with the present invention advantageously reduces its wear and tear. Furthermore, by limiting gaps and/or seams, the buildup of grime is advantageously reduced (without the need for e.g. a delicate plastic cover).

As used herein, and unless otherwise specified, a distinction is made between different types of drinking water. These may be defined relative to the 'starting water' and the 'starting water temperature'. Herein, the starting water is the drinking water that is introduced into the beverage dispenser, and may be processed by it. Typically, the starting water is tap water or bottled water. This starting water has a 'starting water temperature', which is the temperature of said starting water at the time it is introduced into the beverage dispenser. If the starting water temperature is unknown, a temperature of 20 °C may be assumed. Chilled, unchilled and hot water are then respectively drinking water with a temperature lower than, equal to and considerably higher-e.g. at least 25°C higher-than the starting water temperature. Carbonated water (also referred to as 'sparkling water') is-as is well known-drinking water (e.g. starting water) in which carbon dioxide has been dissolved under pressure so as to obtain 'sparkling' drinking water. Still water (also referred to as 'flat water') is drinking water (e.g. starting water) that is not carbonated (i.e.'not sparking'). Typically, the still water may be provided chilled, uncooled, or hot, while the carbonated water is typically provided either chilled or uncooled (not hot). Therefore, 'hot water' is typically understood to mean hot still water. Moreover, 'filtered water' refers to the starting water in the system having been subjected to a filter treatment within the beverage dispenser (that is, in addition to any filter treatment that was performed on the starting water before it was introduced into the beverage dispenser). Finally, 'enhanced water' (also marketed inter alia as 'flavoured water', 'infused water', 'vitaminized water', etc.) is a drinking water with added ingredients, such as (natural or artificial) flavours, vitamins and/or minerals. Enhanced water is generally recognized as being distinct from soft drinks, which typically contain a large amount of sweetener(s). Accordingly, enhanced waters are often proposed/marketed as a low-calorie, healthy alternative to soft drinks (including diet soft drinks). If any, the flavour added to enhanced water is typically rather subtle, in further contrast to soft drinks, coffee and/or tea.

In a first aspect, the present invention relates to a control knob for a beverage dispenser, comprising a first input means and a second input means. The first input means comprises: (i) a control knob housing comprising a selection ring rotatable around a central axis; (ii) a first set of magnets arranged about the central axis and rotating with the selection ring; (iii) a second set of magnets arranged about the central axis and remaining stationary, such that rotating the selection ring yields changes in the interaction forces between the rotating first set of magnets and the stationary second set of magnets; and (iv) a convertor for sensing and converting said rotation of the selection ring to an electronic signal, thereby providing a first input signal. The second input means comprises: (v) a touch button integrated with a portion of the control knob housing such that the touch button is responsive to a mechanical force applied on said portion, thereby providing a second input signal.

Although in some embodiments the central axis may correspond to a real (physical) axle, it is more generally a (theoretical) rotation axis for the rotation of the selection ring.

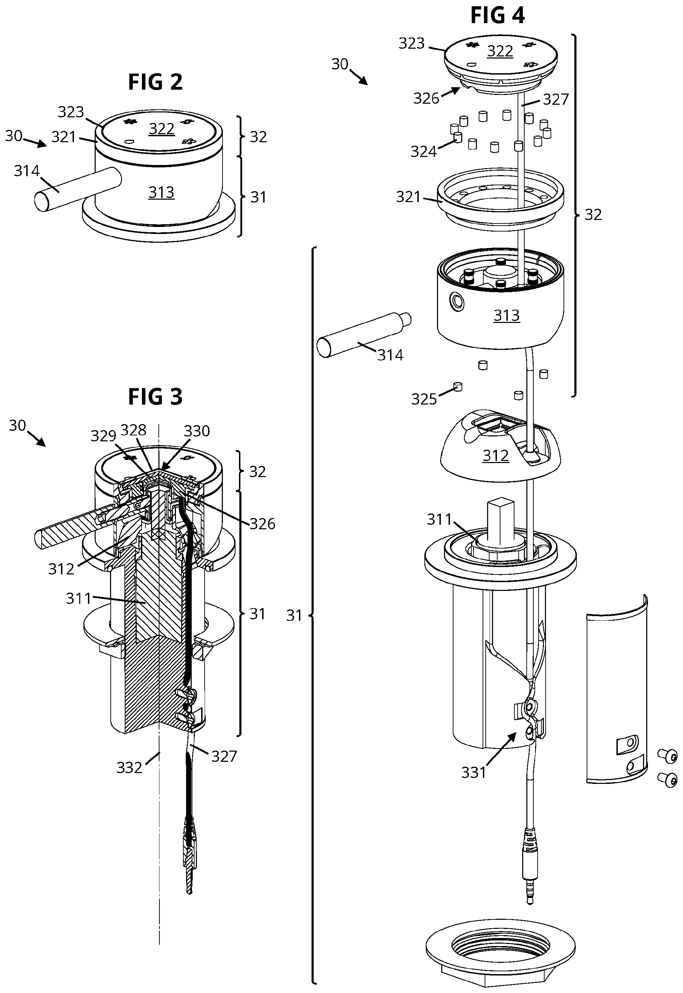

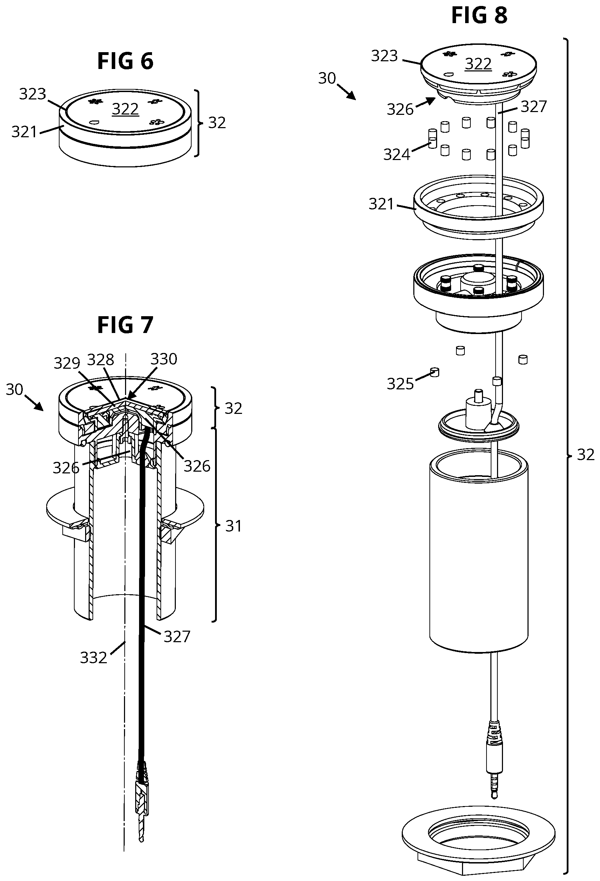

In embodiments, each of the first and second set of magnets may comprise between 2 and 50 magnets, preferably between 3 and 30 magnets, more preferably between 4 and 20 magnets, still more preferably between 6 and 16 magnets; such as 8 or 12 magnets. In preferred embodiments, adjacent magnets within a set may be physically separated from one another (e.g. by an air gap). In other words, the magnets within a set need not form a closed loop, and thus may not be direct in direct physical contact with one another; see for instance the first (324) and second (325) set of magnets in FIG 4 and FIG 8. This is advantageous in that less magnetic material is needed (compared to forming a full loop) and the precise positioning of the magnets (e.g. the alignment of magnets in the first set compared to those in the second set) is somewhat relaxed. Moreover, the first set of magnets may in embodiments comprise a different number of magnets than the second set (i.e. they do not need to comprise the same number each). For example, the ratio of magnets in the first set to those in the second set ([number in the first set]:[number in the second set]) may be 5:4 or less, preferably 5:3 or less, more preferably 3:2 or less, yet more preferably 2:1 or less, most preferably 3:1 or less, such as 4:1 or less; or vice versa (i.e. [number in the second set] :[number in the first set] may be 5:4, etc.). This likewise reduces the amount of magnetic material needed and relaxes the precise positioning of the magnets. In embodiments, the magnets in the first set of magnets may be equidistant from the central axis. For example, the magnets in the first set of magnets may be evenly distributed along a circle of which the centre lies on the central axis (and preferably the plane of the circle is oriented perpendicular to the central axis). In embodiments, the magnets in the second set of magnets may be equidistant from the central axis. For example, the magnets in the second set of magnets may be evenly distributed along a circle of which the centre lies on the central axis (and preferably the plane of the circle is oriented perpendicular to the central axis). In embodiments, the average distance of the first set of magnets to the central axis may be larger than the average of the distance of the second set of magnets to the central axis.

In a simple configuration, each magnet of the first set of magnets may be radially aligned (with respect to the central axis) with a magnet of the second set of magnets; and/or each magnet of the second set of magnets may be radially aligned (with respect to the central axis) with a magnet of the first set of magnets. In such a case, if the magnetization direction of the aligned magnets is parallel, a position of the selection ring in which the magnets align as above will generally be one in which the different (magnetic) forces are in equilibrium-and thus at a local minimum in potential energy. Moreover, there will then typically be a finite number of such rotary positions (i.e. local potential energy minima, wherein the forces are in equilibrium). Notwithstanding, even for more complex situations the latter will generally be true: there will typically always be a finite number of rotary positions in which the different forces are in equilibrium. Since the selection ring will naturally want to 'snap' into one of these positions (or from one such position to the next, if it is being rotated), this advantageously generates a (pleasant) haptic feedback for the user. Although other arrangements are also possible, the magnets in each of the first and the second set of magnets may all have the same orientation with respect to the central axis (e.g. all having their south pole facing the central axis-or vice versa). In other words, for instance the south poles of the magnets in the first set may face towards the central axis and the north poles of the magnets in the second set may face away from the central axis-or vice versa-, so that the south poles in one set face the north poles in the other set. This was advantageously found to create a more pleasant haptic feedback (e.g. because the selection ring-when moving from one stable rotary position to another-does not have to be rotated through a configuration in which the same poles (e.g. N-N or S-S) are directly opposite one another). Moreover, it allows to maximize the number of stable rotary positions (cf. supra) for a given number of magnets. For example, for a case where the magnets in the first set of magnets are radially aligned with those in the second set of magnets-or vice versa-(cf. supra), the number of stable rotary positions is equal to the highest of the number of magnets in the first set and the number in the second set. Conversely, if the poles are alternating within a set (as is e.g. the case in US2020140794A1), the number of stable rotary positions is only half of that.

In embodiments, the first set of magnets may be set into, attached to or integrated with the selection ring.

It will be clear that in this context, the second set of magnets remaining stationary is meant to be contrasted with the first set of magnets rotating with the selection ring, whereas the second set of magnets do not. In other words, the second set of magnets remain stationary relative to the control knob as a whole (but if e.g. the control knob as a whole is moved, the second set of magnets evidently do move with the control knob). In embodiments, the second set of magnets may be set into, attached to or integrated with a part of the control knob which does not rotate with the selection ring (i.e. remains stationary).

The convertor senses the rotation (e.g. the amount-and optionally direction-of rotation and/or the angular orientation) of the selection ring, and converts the sensed rotation into an electronic signal. To that end, the convertor may comprise one or more sensors (e.g. magnetic sensors, such as two Hall sensors, or optical sensors) for sensing a rotation of the selection ring.

In embodiments, the convertor may be, or may be comprised in, a control unit. In embodiments, the control unit may be a circuit board (e.g. printed circuit board, PCB). In embodiments, the control unit may further output an electronic signal corresponding to a selection made using the selection ring and/or touch button (e.g. outputting the first input signal and/or the second input signal; or outputting an electronic signal derived therefrom, such as an electronic signal derived from a combination of the first and second signal). The control unit may furthermore be connectable to one or more exterior components, such as an (electronic) valve system, cooler, heater, carbonator, etc. In embodiments, the connection may be for a one-way communication (e.g. from the controller to the valve system) or for a two-way combination (e.g. between the controller and a cooler, heater or carbonator). In embodiments, the connection may be a wired (e.g. using a connection cable) or wireless connection, preferably a wired connection. When using a wired connection,-particularly if the connection cable is subject to movement (e.g. when the control knob is integrated on a tap lever-cf. the second aspect-and thus needs to be able to tilt and rotate with the tap lever)-the control knob may further comprise one or more strain reliefs. In embodiments, the control unit may be encapsulated or potted. This advantageously allows to further protect the control unit from moisture and other potentially damaging contaminants.

In embodiments, the touch button may be responsive to a mechanical force of at most 2 N applied on the portion of the control knob housing with which the touch button is integrated; preferably at most 1 N, more preferably at most 0.5 N, yet more preferably at most 0.2 N, still yet more preferably at most 0.1 N.

In embodiments, the touch button may be integrated with a top of the control knob housing. For example, the control knob may comprise a cover plate which forms part of the touch button. In embodiments, said top of the control knob housing may abut the central axis. In embodiments, the touch button may be a touch-on-metal button or a piezo touch button; preferably a touch-on-metal button. Touch-on-metal buttons and piezo touch buttons advantageously both lack moving mechanical parts, which makes them less prone to wear and tear and ensures a longer lifespan. In addition, they are insensitive to dirt, moisture and other contaminants commonly found around beverage dispensers. Moreover, they can be designed to be completely sealed, making them further resistant to spills and the like of the aforementioned. The fact they can be sealed and moreover that their touch area can be made from metals like stainless steel or brass-with a flat surface and lack of crevices-also makes them less likely to harbour bacteria while also being easy to clean and sanitize, which is essential for maintaining good hygiene and which further enhances their suitability for use around drink and food. These advantages are especially relevant since beverage/drinking water dispensers like kitchen taps are typically expected to have a lifetime of up to several decades (e.g. 200.000 use cycles or more), so that it desirable for their components to be rated accordingly.

In embodiments wherein the touch button is a touch-on-metal button, the convertor may further comprise an inductor (e.g. an induction coil) for sensing an effective inductance. The inductor may typically be configured under-but not in direct contact with-a metal plate (or 'metal sheet'). The portion of the control knob housing which is part of the touch button may then be the metal plate as such, or a cover mechanically coupled to (e.g. in direct or indirect contact with, such as over or on) the metal plate. Preferably, there may be a gap (e.g. an air gap, or at least a compressible gap) between the metal plate and the inductor. In embodiments, the touch button may further comprise one or more standoffs (e.g. near an outer edge of the metal plate) for ensuring the gap. In embodiments,-when the metal plate is not deflected (i.e. no external force exerted thereon)-the gap may have a minimum height of from 0.05 mm to 2 cm, preferably from 0.10 cm to 1 cm, more preferably from 0.15 cm to 0.7 cm, such as from 0.20 cm to 0.5 cm. In embodiments,-when the metal plate is deflected (e.g. touched)-the remaining gap may have a minimum height of at least 0.01 mm, preferably at least 0.05 cm, more preferably at least 0.10 cm, such as at least 0.15 cm. In embodiments, a maximum travel distance of any portion of the metal plate between a state wherein no touch is detected and a state wherein a touch is detected may be at most 500 µm, preferably at most 200 µm, more preferably at most 100 µm, still more preferably at most 50 µm; such as around 20 to 50 µm. Without being bound by theory, applying a (small) mechanical force (e.g. touching) to the metal plate causes a (micro)deflection thereof. Being made of (or at least comprising) a conductor, if the metal plate is brought into the vicinity of the inductor's AC magnetic field, small circulating eddy currents will be induced by the magnetic field onto the surface of the conductor. These eddy currents in turn produce their own magnetic field that opposes the one created by the inductor which reduces the effective inductance of the inductor. The resulting inductance shift can then be measured by the control unit and can be used to provide information about the position of the metal plate over the inductor (even allowing to distinguish between different distances or equivalently forces applied to the metal plate). Touch-on-metal buttons thereby have the further advantage that they can be fairly easily recalibrated, so that changes over time in the metal plate-inductor gap (e.g. due to wear or due to a smaller mishap, like a sturdy object colliding with the metal plate) can be accounted for.

In embodiments wherein the touch button is a piezo touch button, the convertor may further comprise an electronic circuit electrically coupled to a piezoelectric element (e.g. comprising a polymeric, crystalline or ceramic piezoelectric material), for sensing an electrical charge generated by the piezoelectric element (e.g. when a small mechanical force-e.g. a touch on the cover, cf. infra-is applied to the piezoelectric element). The piezoelectric element is not normally used as an exterior surface (i.e. it is not normally exposed in the control knob), so the portion of the control knob housing which is part of the touch button may in this case typically be a cover mechanically coupled to (e.g. in direct or indirect contact with, such as over or on) the piezo assembly.

In embodiments, the control knob may further comprise: (vi) an electronic selection indicator for indicating a selection made using the selection ring and/or touch button. For example, the control unit may be communicatively coupled (e.g. wired or wirelessly, preferably wired) to the selection ring and/or the touch button, and to the electronic selection indicator. In embodiments, the control unit may be configured for determining the selection made using the selection ring and/or touch button (e.g. from the first and/or second input signal), and for controlling the electronic selection indicator to indicate said selection made. Notwithstanding, the electronic selection indicator may in some embodiments be used more broadly, for example to indicate a status, warning, reminder or error message (e.g. related to a further component of the beverage system, such as an (electronic) valve system, filter, CO₂ bottle, cooler, heater/boiler, etc.).

In embodiments, the electronic selection indicator may comprise a light guide and one or more light sources shining into the lightguide. For example, the control unit may be communicatively coupled (e.g. wired or wirelessly, preferably wired) to the light sources, and said light sources may be controlled by the control unit. In embodiments, the one or more light sources may comprise one or more light-emitting diodes (LEDs). In embodiments, the one or more light sources may comprise distinct colours and/or multi-coloured light sources. In embodiments, the light guide may be divided into individual light zones. The individual light zones may advantageously be lit up individually (e.g. by appropriately activating the one or more light sources). In embodiments, the control knob may further comprise markers (e.g. (laser) engravings in the top or side housing) indicating a meaning for one or more light zones. In embodiments, the light guide may be divided into individual light zones using one or more inserts. For example, adjacent light zones may be separated by an insert. Said inserts are non-transparent towards light from the light sources, so that-when one light zone is lit up by a light source associated therewith-he light may be blocked by the insert(s) from propagating towards neighbouring light zones.

In embodiments, the control knob may allow to make a selection between at least 3, preferably at least 4, yet more preferably at least 5 different options. In embodiments, the control knob may allow to make a selection between different beverage types, preferably drinking water types.

In embodiments, at least a major exterior surface of the control knob housing may be made of a metal. In embodiments, the control knob housing may be predominantly (e.g. more than 50%, preferably at least 70%, more preferably at least 80%, still more preferably at least 90%, most preferably at least 95%) made from a metal. In embodiments, the metal may be a corrosion resistant metal, preferably stainless steel and/or brass. Such metals typically advantageously have physicochemical (e.g. hardness, wear resistance, and corrosion resistance) and sanitary (e.g. ease of cleaning) properties which make them favourable for use in applications involving drink and/or food for human consumption.

In embodiments, the selection ring may have an exterior surface which is smooth or patterned (e.g. knurled), preferably patterned. A patterned exterior surface can advantageously help increase the grip on-and thus ease of manipulating-the selection ring.

In embodiments, any feature of any embodiment of the first aspect may independently be as correspondingly described for any embodiment of any of the other aspects.

In a second aspect, the present invention relates to a tap lever having integrated thereon a control knob according to any embodiment of the first aspect.

In embodiments, the tap lever may be for a single-lever mixer tap.

In embodiments, the tap lever may further comprise a connection cable running from the control knob through the tap lever. In embodiments, the tap lever may further comprise a strain relief for the connection cable.

In embodiments, any feature of any embodiment of the second aspect may independently be as correspondingly described for any embodiment of any of the other aspects.

In a third aspect, the present invention relates to a system comprising: a beverage dispenser; and a control knob according to any embodiment of the first or second aspect.

In embodiments, the beverage dispenser may be a tap. In preferred embodiments, the tap may be a water tap. For example, the tap may be a mixer tap.

In embodiments, the control knob may be integrated on the beverage dispenser.

In embodiments, the control knob may be mounted on a same surface as the beverage dispenser.

In embodiments, a major exterior surface of the control knob housing and a major exterior surface of the beverage dispenser may be made of a same material; preferably a metal. In embodiments, the beverage dispenser may comprise a beverage dispenser housing; and the control knob housing and beverage dispenser housing may be predominantly made of a same material; preferably a metal. In embodiments, the metal may be a corrosion resistant metal, preferably stainless steel and/or brass.

In embodiments, the beverage dispenser may be adapted to produce two or more of the beverage types starting from a common water source; preferably at least two or more beverage types. Said common water source may be understood to be a 'starting water' from which the beverage types are to be prepared. Said common water source may, for example, be a tap water source, which is an economically and ecologically friendly water source. However, other sources-such as replaceable (large) water bottles-could likewise be used as the common water source.

In embodiments, the beverage dispenser may further comprise a filtering system for filtering water, and/or a chiller for chilling water, and/or a heater (which may also be referred to as a 'boiler') for heating water, and/or a carbonator for carbonating water, and/or one or more stations for producing enhanced water. It is an advantage of these embodiments that the filtering system and/or the chiller and/or the heater and/or the carbonator and/or stations may be used to prepare the different beverage types from the common water source.

Filtering the starting water from the common water source may remove any impurities, which may influence the quality (e.g. pH), smell, and taste of the water. In embodiments, the filtering system may be configured for reducing the hardness of the starting water from the common water source.

In preferred embodiments, the beverage dispenser may be drinking water dispenser. In preferred embodiments, the beverage type (e.g. the drinking water type) may be selected from at least still water and sparkling water; preferably at least still water, sparkling water and hot water; yet more preferably at least still water, sparkling water, hot water and one or more types of enhanced water. These may be filtered or unfiltered. For example, the drinking water type may be selected from unfiltered chilled water, unfiltered hot water, chilled filtered still water, chilled filtered sparkling water, hot filtered water and-optionally-one or more types of enhanced water.

In embodiments, the hot water may have a temperature of from 50° C to 100° C, preferably from 60°C to 99°C, more preferably from 75°C to 98°C. Said hot water may be prepared by heating water from the common water source using the heater. Preferably, before heating the water from the common water source, the water is first filtered, at least so as to reduce the hardness of the water (e.g. so as to reduce the carbonate content of the water, and reduce the precipitation of lime in the beverage dispenser). It is an advantage of these embodiments that said hot water may be suitable for preparing tea, coffee (e.g. instant coffee or filter coffee), soup, and/or chocolate milk. Notwithstanding, the dispensation of hot water does pose a certain safety risk-particularly for children-and may therefore be subject to additional limitations. For example, it may upon choosing hot water using the selection ring, dispensing the hot water by a simply touching the touch button is impossible and that a more involved interaction must be performed (e.g. keeping the touch button pressed for some time, and/or requiring multiple touches to 'unlock' the hot water).

The still or sparkling water may be chilled or unchilled. Chilled water may have a temperature of from 0°C to 15°C, preferably from 2°C to 12°C. Said chilled water may be prepared by chilling the common water source using the chiller.

In embodiments, the beverage dispenser may further comprise a valve for each (or at least a plurality thereof) beverage type. The valves may be mechanical valves, electronic valves or a combination thereof. Preferably, each valve may be fluidically connected to a single nozzle (e.g. a single tap) or a plurality of adjacent nozzles (e.g. a single tap with two adjacent nozzles). Using a common nozzle or adjacent nozzles advantageously simplifies interacting with the beverage dispenser for a user and may typically be found to yield a better aesthetics.

In some embodiments, the beverage dispenser may further comprise a flavour distributing system. Said flavour distributing system may e.g. comprise a plurality of syrups (e.g. infusion-, soft drink-, iced-tea- and/or tea-flavoured syrups) and/or powders (e.g. coffee powder, such as instant coffee powder, or a powder for making a sports drink). Each syrup and/or powder may be contained in a respective bottle or cup. The syrups and/or powders may typically comprise differently flavoured syrups and/or powders. The flavour distributing system may thus be for distributing a flavour selected from a plurality of different flavours. The syrup distributing system may be configured for providing a predetermined amount (which may depend on the flavour in question) of a syrup and/or powder to a water type, so as to obtain a beverage type with the selected flavour. The beverage type with added flavour may be chilled or unchilled, but is preferably chilled. The beverage type with added flavour may be sparkling or still. It is an advantage of these embodiments that a wide range of beverage types having a range of different flavours may be obtained by mixing water with a syrup and/or powder. In preferred embodiments, the beverage type with added flavour may be an enhanced water.

In embodiments, any feature of any embodiment of the third aspect may independently be as correspondingly described for any embodiment of any of the other aspects.

In a fourth aspect, the present invention relates to a method for using a control knob as defined in any embodiment of the first or second aspect, comprising manipulating the selection ring and/or touch button to make a selection.

In embodiments, the method may further comprise dispensing the selected beverage. Preferably, the selected beverage may be dispensed into a beverage container. The beverage container may be any type of container suitable for containing beverages, such as a mug, a glass, a cup, a bottle or a pot. The beverage container may be made of, for example, glass, porcelain, wood, metal, carton or paper.

In embodiments, any feature of any embodiment of the fourth aspect may independently be as correspondingly described for any embodiment of any of the other aspects.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: Control knob integrated atop a tap lever ('combi tap control')

### Example 1A: Control separate from the tap

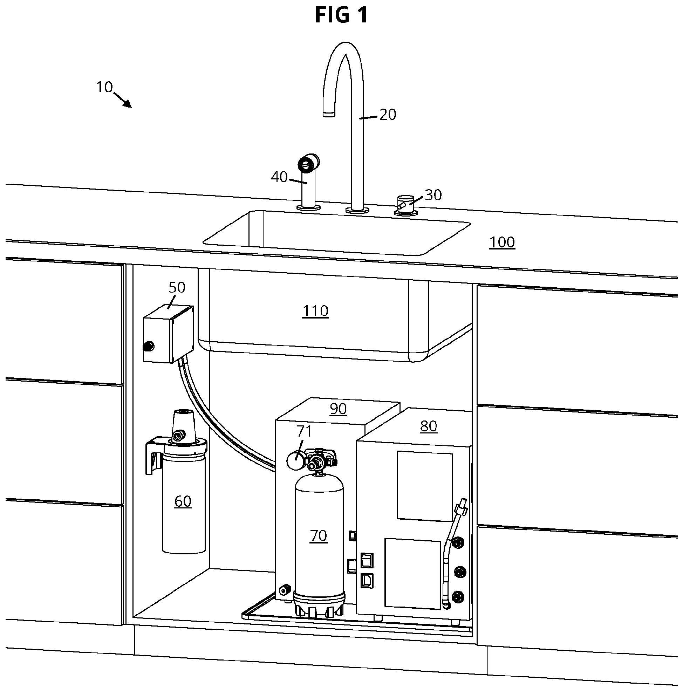

FIG 1 schematically depicts an illustrative beverage system (10; more specifically a drinking water system) in accordance with the present invention. It comprises a tap (20), 'combi tap control' (30) and hand sprayer (40) mounted on a countertop (100). The outer housing of the tap (20), combi tap control (30) and hand sprayer (40) is predominantly made out of stainless steel and/or brass. The system (10) further includes an electronic valve system (50), filter (60), CO₂ bottle (70) with pressure regulator (71), cooler (80) and heater/boiler (90) mounted below a sink (110) in the countertop (100). Note that for simplicity, several connections (e.g. water pipes) between the different components are not visualized in FIG 1. It will be evident that many variations on this system (10) are possible, to name but a few: several components are optional and can be omitted if their function is not desired (e.g. in particular the hand sprayer 40 and heater 90), or others may be added (e.g. one or more stations for producing enhanced water); the electronic valve system (50) need not be provided in a separate box, but could also be integrated in another component (e.g. in the cooler 80 or heater 90); and the configuration of components is flexible and several components could be provided in a different location, including a remote location (e.g. the filter 60, CO₂ bottle 70, cooler 80 and/or heater 90 could be stationed remotely; for example to increase safety and/or reduce perceivable noise).

The combi tap control (30)-shown in closer view in FIG 2-comprises a tap lever (31) with a control knob (32) integrated thereon, and combines control over normal hot and cold tap water with that over additional beverage/drinking water types (e.g. filtered chilled, sparkling, hot and/or enhanced water) in a single body. To that end, the tap lever (31) may typically be for controlling the hot and cold tap water (like in a more traditional single-lever mixer tap), while the control knob (32) may typically be used for controlling the further beverage types.

FIG 3 and FIG 4 respectively schematically depict a cutout view and an exploded view of the full combi tap control (30) (i.e. including the parts extending below the countertop 100). Like in a single-lever mixer tap, the regular hot and cold tap water temperature can thus be managed by rotating the tap lever (31), while the water flow rate can be regulated by tilting the tap lever (31). To that effect, the combi tap control (30) may for example comprise a single-lever mixer cartridge (311), cable guard (312) and lever knob base (313) with handle (314).

Conversely, the control knob (32) comprises a selection ring (321), touch button (322) and electronic selection indicator (323). Control over the further beverage types can then for example entail rotating the selection ring (321) to select the desired type of beverage, with visual feedback provided by the selection indicator (323), followed by dispensing the selected beverage by touching (very lightly pushing) the touch button (322). An electronic signal corresponding to the desired action is then sent via a connection cable (327; e.g. a data cable) to a control unit in the electronic valve system (50). In turn, this control unit regulates (e.g. using solenoid valves) the dispensation of the selected beverage (typically from tap 20 / nozzle(s) 21). Moreover, since the connection cable (327) is subject to movement (e.g. when the tap lever is manipulated), a strain relief (331) for the connection cable (327) is also foreseen.

More in particular, the control knob (32) comprises a first set of magnets (324) which are placed (equidistantly) into the selection ring (321)-and are thus rotatable with the selection ring (321)-and a second set of magnets (325) placed (equidistantly) into the lever knob base (314)- and are thus not rotating with the selection ring 321). Over a full rotation of the selection ring (321) then, the attractive and repulsive forces between the magnets create a finite number of positions for the selection ring (321) in which the different magnets are configured such that said forces are said in equilibrium (i.e. corresponding to a local minimum in potential energy). Accordingly, rotating the selection ring (321) generates a form of haptic feedback (similar to a 'click' sensation) as the selection ring (321) snaps from one such position to the next.

Simultaneously, it is also possible to sense (e.g. via changes in the magnetic field) a rotation of the selection ring (321) due to the first set of magnets (324) moving relative to the second (325). To this end, the control knob (32) further comprises a control unit (326; e.g. a printed circuit board, PCB) with one or more sensors (e.g. two Hall sensors) for sensing a rotation of the selection ring (321).

The touch button (322) in this example uses inductive touch technology (also referred to as 'Touch-on-Metal') and comprises a metallic cover plate (328; preferably in the same material as the tap housing) and an induction coil (329) under the cover plate (328) (e.g. on/in the control unit 326), with a (small) gap (330) between both. Accordingly, (small) deflections of the cover plate (328) cause an induction shift measurable through the induction coil (329). Thus, when touching the button (322), the cover plate (328) becomes slightly bent and this can be sensed by the induction coil (329) and control unit (326) (which can convert it into an electronic signal). Optionally, the control unit (326) may be further configured to re-calibrate (occasionally-e.g. periodically-and/or on demand) the baseline induction (i.e. when the cover plate 328 is not touched) sensed by the induction coil (329). As such, the touch button (322) can be made resistant to wear or accidents (e.g. a pot colliding with the cover plate 328) which permanently (slightly) change the default configuration of the cover plate (328) as such and/or between the cover plate (328) and the induction coil (329).

The selection indicator (323) may for example comprise a light guide with individual light zones (e.g. realized by placing an insert in-between adjacent light zones), and one or more light sources (e.g. light-emitting diodes, LEDs-optionally having different colours) controlled by the control unit (326) and shining into the light guide such that the light zones can be lit up individually. As such, visual feedback on the current selection and/or status information can be given by lighting up one or more of the light zones. As visualized in FIG 2, the cover plate (328) further comprises markers next to each light zone which indicate their meaning.

Finally, the control unit (326) is further configured to register the inputs made using the selection ring (321) and touch button (322), processing these inputs (e.g. relating them to a desired selection) and to output a corresponding electronic signal (e.g. to the electronic valve system 50, but optionally also to the cooler 80 and/or heater 90). Depending on the needs of the system (10), the control unit (326) may not be simply able to output the electronic signal to the electronic valve system (50), filter (60), cooler (80) and/or heater (90), but may be in (two-way) communication therewith-so that it can also receive signals from the electronic valve system (50), filter (60), cooler (80) and/or heater (90), which can for example allow to display status messages from these components onto the selection indicator (323).

### Example 1B: Control integrated on the tap

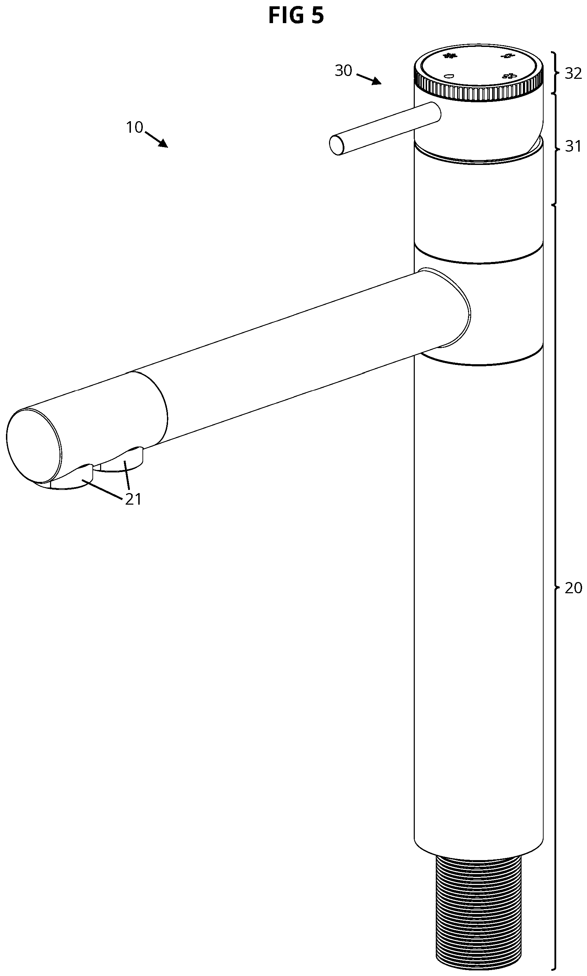

As depicted in FIG 5, another illustrative beverage system (10) is similar to that of Example 1A, but instead of being mounted on the countertop (100) the combi tap control (30) is integrated atop the tap (20). The tap (20) moreover comprises two adjacent nozzles (21), for example one nozzle for the regular hot and cold tap water and another for the additional beverage/drinking water types.

Note moreover that while the outer surface of the selection ring (321) in FIG 2 was smooth, it is patterned (e.g. knurled) in FIG 5; which is an option that is not exclusive to the present example but could generally be present in any embodiment.

### Example 2: Control knob without tap lever

### Example 2A: Control separate from the tap

As depicted in FIG 6, a further variant of the illustrative beverage system (10) is again similar to that of Example 1A, but without the mechanical control for hot and cold tap water. As such, the control knob (32)-without tap lever (31)-(of which a cutout view is shown in FIG 7 and an exploded view in FIG 8) is mounted directly on the countertop (100).

### Example 2B: Control integrated on the tap

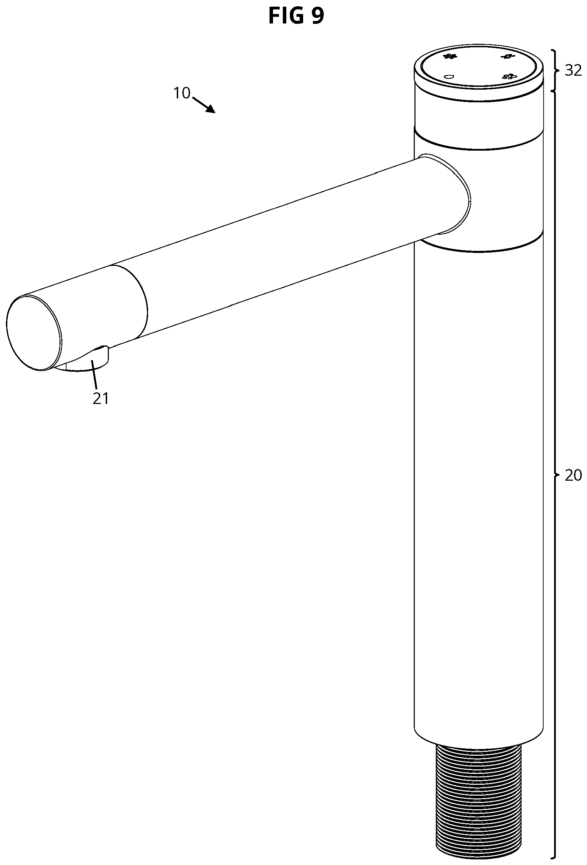

As depicted in FIG 9, also in the configuration of Example 2A, the control knob (32) can be integrated atop the tap (20). In this example, the tap (20) only has one nozzle (21).

It is to be understood that although preferred embodiments, specific constructions, configurations and materials have been discussed herein in order to illustrate the present invention. It will be apparent to those skilled in the art that various changes or modifications in form and detail may be made without departing from the scope of the invention as defined in the appended claims.

## Claims

1. A control knob (32) for a beverage dispenser, comprising:
a first input means comprising:
i. a control knob housing comprising a selection ring (321) rotatable around a central axis (332);
ii. a first set of magnets (324) arranged about the central axis (332) and rotating with the selection ring (321);
iii. a second set of magnets (325) arranged about the central axis (332) and remaining stationary, such that rotating the selection ring (321) yields changes in the interaction forces between the rotating first set of magnets (324) and the stationary second set of magnets (325); and
iv. a convertor for sensing and converting said rotation of the selection ring (321) to an electronic signal, thereby providing a first input signal; and
a second input means comprising:
v. a touch button (322) integrated with a portion (328) of the control knob housing such that the touch button (322) is responsive to a mechanical force applied on said portion (328), thereby providing a second input signal.

2. The control knob (32) according to claim 1, wherein the touch button (322) is a touch-on-metal button or a piezo touch button; preferably a touch-on-metal button.

3. The control knob (32) according to any of the previous claims, wherein the touch button (322) is integrated with a top of the control knob housing.

4. The control knob (32) according to any of the previous claims, wherein each of the first (324) and second (325) set of magnets comprise between 2 and 50 magnets, preferably between 3 and 30 magnets, more preferably between 4 and 20 magnets, still more preferably between 6 and 16 magnets.

5. The control knob (32) according to any of the previous claims, further comprising:
vi. an electronic selection indicator (323) for indicating a selection made using the selection ring (321) and/or touch button (322).

6. The control knob (32) according to claim 5, wherein the electronic selection indicator (323) comprises a light guide and one or more light sources shining into the lightguide.

7. The control knob (32) according to claim 6, wherein the light guide is divided into individual light zones using one or more inserts.

8. The control knob (32) according to any of the previous claims, allowing to make a selection between at least 3, preferably at least 4, yet more preferably at least 5 different options.

9. The control knob (32) according to any of the previous claims, allowing to make a selection between different drinking water types.

10. A tap lever (31) having integrated thereon a control knob (32) according to any of the previous claims.

11. A system (10) comprising:
- a beverage dispenser; and
- a control knob (32) according to any of the previous claims.

12. The system (10) according to claim 11, wherein the beverage dispenser is a tap (20).

13. The system (10) according to any of claims 11 to 12, wherein the control knob (32) is integrated on the beverage dispenser.

14. The system (10) according to any of claims 11 to 13, wherein a major exterior surface of the control knob housing and a major exterior surface of the beverage dispenser are made of a same material; preferably a metal.

15. A method for using a control knob (32) as defined in any of the previous claims, comprising manipulating the selection ring (321) and/or touch button (322) to make a selection.

## Patentansprüche

1. Ein Steuerknopf (32) für einen Getränkespender, umfassend:
- ein erstes Eingabemittel, umfassend:
i.- ein Steuerknopfgehäuse, das einen um eine zentrale Achse (332) drehbaren Auswahlring (321) umfasst;
ii.- einen ersten Satz von Magneten (324), die um die zentrale Achse (332) herum angeordnet sind und sich mit dem Auswahlring (321) drehen;
iii.- einen zweiten Satz von Magneten (325), die um die zentrale Achse (332) herum angeordnet und stationär bleiben, sodass Drehen des Auswahlrings (321) Änderungen bei den Wechselwirkungskräften zwischen dem sich drehenden ersten Satz von Magneten (324) und dem stationären zweiten Satz von Magneten (325) ergibt; und
iv.- einen Wandler zum Erfassen und Umwandeln der Drehung des Auswahlrings (321) in ein elektronisches Signal, wodurch ein erstes Eingangssignal bereitgestellt wird; und
- ein zweites Eingabemittel, umfassend:
v.- eine Berührungstaste (322), die mit einem Abschnitt (328) des Steuerknopfgehäuses integriert ist, sodass die Berührungstaste (322) auf eine auf diesen Abschnitt (328) ausgeübte mechanische Kraft reagiert, wodurch ein zweites Eingangssignal bereitgestellt wird.

2. Der Steuerknopf (32) nach Anspruch 1, wobei die Berührungstaste (322) eine Metall-Berührungstaste oder eine Piezo-Berührungstaste ist; vorzugsweise eine Metall-Berührungstaste.

3. Der Steuerknopf (32) nach einem der vorstehenden Ansprüche, wobei der Berührungsknopf (322) mit einer Oberseite des Steuerknopfgehäuses integriert ist.

4. Der Steuerknopf (32) nach einem der vorstehenden Ansprüche, wobei jeder von dem ersten (324) und zweiten (325) Satz von Magneten zwischen 2 und 50 Magneten, vorzugsweise zwischen 3 und 30 Magneten, bevorzugter zwischen 4 und 20 Magneten und noch bevorzugter zwischen 6 und 16 Magneten umfasst.

5. Der Steuerknopf (32) nach einem der vorstehenden Ansprüche, weiter umfassend:
vi.- einen elektronischen Auswahlindikator (323) zur Angabe einer unter Verwendung des Auswahlrings (321) und/oder der Berührungstaste (322) getroffenen Auswahl.

6. Der Steuerknopf (32) nach Anspruch 5, wobei der elektronische Auswahlindikator (323) einen Lichtleiter und eine oder mehrere in den Lichtleiter scheinende Lichtquellen umfasst.

7. Der Steuerknopf (32) nach Anspruch 6, wobei der Lichtleiter unter Verwendung eines oder mehrerer Einsätze in einzelne Lichtzonen unterteilt ist.

8. Der Steuerknopf (32) nach einem der vorstehenden Ansprüche, der es ermöglicht, eine Auswahl zwischen mindestens 3, vorzugsweise mindestens 4, noch bevorzugter mindestens 5 verschiedenen Optionen zu treffen.

9. Der Steuerknopf (32) nach einem der vorstehenden Ansprüche, der es ermöglicht, eine Auswahl zwischen verschiedenen Trinkwassersorten zu treffen.

10. Ein Zapfhahnhebel (31), der darin integriert einen Steuerknopf (32) nach einem der vorstehenden Ansprüche aufweist.

11. Ein System (10), umfassend:
- einen Getränkespender; und
- einen Steuerknopf (32) nach einem der vorstehenden Ansprüche.

12. Das System (10) nach Anspruch 11, wobei der Getränkespender ein Zapfhahn (20) ist.

13. Das System (10) nach einem der Ansprüche 11 oder 12, wobei der Steuerknopf (32) auf den Getränkespender integriert ist.

14. Das System (10) nach einem der Ansprüche 11 bis 13, wobei eine Hauptaußenoberfläche des Steuerknopfgehäuses und eine Hauptaußenoberfläche des Getränkespenders aus einem gleichen Material gefertigt sind; vorzugsweise aus Metall.

15. Ein Verfahren zur Verwendung eines Steuerknopfes (32) nach einem der vorstehenden Ansprüche, umfassend das Manipulieren des Auswahlrings (321) und/oder der Berührungstaste (322), um eine Auswahl zu treffen.

## Revendications

1. Bouton de commande (32) pour un distributeur de boissons, comprenant :
un premier moyen d'entrée comprenant :
i. un boîtier du bouton de commande comprenant une bague de sélection (321) rotative autour d'un axe central (332) ;
ii. un premier ensemble d'aimants (324) disposé autour de l'axe central (332) et tournant avec la bague de sélection (321) ;
iii. un second ensemble d'aimants (325) disposé autour de l'axe central (332) et restant fixe, de sorte que la rotation de la bague de sélection (321) entraîne des variations dans les forces d'interaction entre le premier ensemble rotatif d'aimants (324) et le second ensemble fixe d'aimants (325) ; et
iv. un convertisseur pour détecter et convertir ladite rotation de la bague de sélection (321) en un signal électronique, fournissant ainsi un premier signal d'entrée ; et
un second moyen d'entrée comprenant :
v. un bouton tactile (322) intégré à une partie (328) du boîtier du bouton de commande de sorte que le bouton tactile (322) soit sensible à une force mécanique appliquée sur ladite partie (328), fournissant ainsi un second signal d'entrée.

2. Bouton de commande (32) selon la revendication 1, dans lequel le bouton tactile (322) est un bouton tactile sur métal ou un bouton tactile piézoélectrique ; de préférence un bouton tactile sur métal.

3. Bouton de commande (32) selon l'une quelconque des revendications précédentes, dans lequel le bouton tactile (322) est intégré à une partie supérieure du boîtier du bouton de commande.

4. Bouton de commande (32) selon l'une quelconque des revendications précédentes, dans lequel chacun des premier (324) et second (325) ensembles d'aimants comprend entre 2 et 50 aimants, de préférence entre 3 et 30 aimants, plus préférentiellement entre 4 et 20 aimants, et encore plus préférentiellement entre 6 et 16 aimants.

5. Bouton de commande (32) selon l'une quelconque des revendications précédentes, comprenant en outre :
vi. un indicateur de sélection électronique (323) pour indiquer une sélection effectuée à l'aide de la bague de sélection (321) et/ou du bouton tactile (322).

6. Bouton de commande (32) selon la revendication 5, dans lequel l'indicateur de sélection électronique (323) comprend un guide de lumière et une ou plusieurs sources lumineuses éclairant à l'intérieur du guide de lumière.

7. Bouton de commande (32) selon la revendication 6, dans lequel le guide de lumière est divisé en zones lumineuses individuelles à l'aide d'un ou plusieurs inserts.

8. Bouton de commande (32) selon l'une quelconque des revendications précédentes, permettant de faire une sélection parmi au moins 3, de préférence au moins 4, et encore plus préférentiellement au moins 5 options différentes.

9. Bouton de commande (32) selon l'une quelconque des revendications précédentes, permettant de faire une sélection parmi différents types d'eau potable.

10. Levier de robinet (31) sur lequel est intégré un bouton de commande (32) selon l'une quelconque des revendications précédentes.

11. Système (10) comprenant :
- un distributeur de boissons ; et
- un bouton de commande (32) selon l'une quelconque des revendications précédentes.

12. Système (10) selon la revendication 11, dans lequel le distributeur de boissons est un robinet (20) .

13. Système (10) selon l'une quelconque des revendications 11 à 12, dans lequel le bouton de commande (32) est intégré sur le distributeur de boissons.

14. Système (10) selon l'une quelconque des revendications 11 à 13, dans lequel une surface extérieure principale du boîtier du bouton de commande et une surface extérieure principale du distributeur de boissons sont constituées d'un même matériau ; de préférence un métal.

15. Procédé d'utilisation d'un bouton de commande (32) tel que défini dans l'une quelconque des revendications précédentes, comprenant la manipulation de la bague de sélection (321) et/ou du bouton tactile (322) pour faire une sélection.
